Europäisches Patentamt

(19) European Patent Office

Office européen des brevets

(11) Publication number: **0 245 808**
A2

(12) **EUROPEAN PATENT APPLICATION**

(21) Application number: **87106770.8**

(22) Date of filing: **09.05.87**

(51) Int. Cl.³: **H 03 M 1/20**

(30) Priority: **13.05.86 US 862738**

(43) Date of publication of application:
**19.11.87 Bulletin 87/47**

(84) Designated Contracting States:
**DE GB**

(71) Applicant: **HONEYWELL INC.**
Honeywell Plaza
Minneapolis Minnesota 55440(US)

(72) Inventor: **Chan, Wan-on**
352 Summerset Drive
Streanwood Illinois 60103(US)

(74) Representative: **Rentzsch, Heinz**
Honeywell Europe S.A. Holding KG Patent- und
Lizenzabteilung Kaiserleistrasse 55
D-6050 Offenbach am Main(DE)

(54) Improved resolution analog to digital converter.

(57) For enhancing the resolution of an analog to digital converter the voltage level of the input signal is shifted by a variety of amounts therewith a wider range of voltages fitting into the available dynamic range of the converter. The amount of shift selected may also be used to add additional bits to the digital signal.

FIG.2

HONEYWELL INC.

Honeywell Plaza

Minneapolis, MN 55440 USA

May 8, 1987

C2011869 EP

HR/de

0245808

## IMPROVED RESOLUTION ANALOG TO DIGITAL CONVERTER

The present application relates to analog to digital converters and more specifically to an analog to digital converter having enhanced resolution.

In a data acquisition system a number of analog inputs will commonly be converted to digital signals in order that those signals may be processed by a microprocessor or other digital signal processing equipment. In some cases some of the signals will require greater digital resolution than others. In the past, the practice was either to use separate analog to digital converters with varying amounts of resolution or to use one analog to digital decoder having a resolution equal to the highest required and multiplex the analog input signals thereto.

These techniques have a disadvantage because the higher resolution analog to digital converters are significantly more complex and more expensive than the lower resolution ones. It is the object of the present invention to provide higher resolution from a low resolution analog to digital converter. This is achieved by the apparatus as described in claim 1. Preferred improvements are disclosed in the subclaims.

The invention includes a circuit for shifting the voltage level of the signal which is to be analog to digital converted. By providing a variety of amounts of voltage shift, a wider range of voltages may be compressed to fit the available dynamic range of the analog to digital converter. The amount of shift selected may also be used to add additional bits to the digital signal, and therewith to enhance the resolution for the analog to digital converter. The invention will be described with reference to embodiments shown in the drawings, wherein:

Figure 1 is an electrical schematic diagram illustrating the basic concept of the voltage level shifting aspect of the invention;

Figure 2 is an electrical schematic diagram illustrating the use of the invention with a single signal; and

Figure 3 is an electrical schematic diagram illustrating an embodiment of the invention in which a number of signals are multiplexed for conversion by the same analog to digital converter.

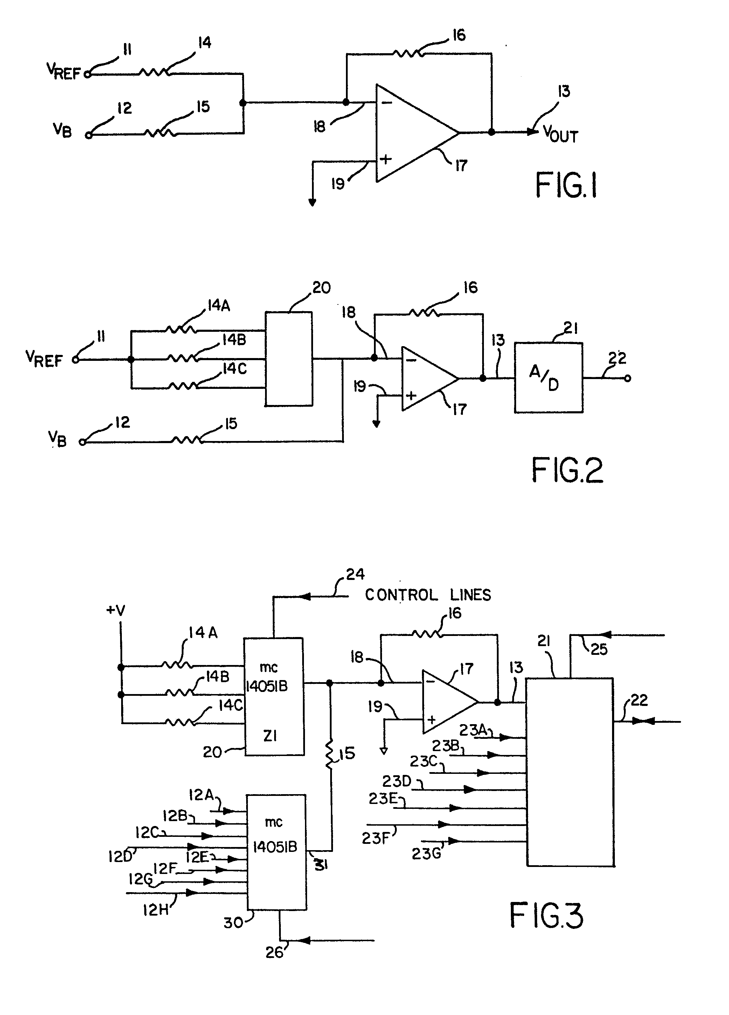

In the present invention a signal level which is to be analog to digital converted is subjected to a level shifting process in order to maintain that signal within the range of an analog to digital converter which is intended to operate on the signal. Figure 1 illustrates the basic concept of this level shifting. In Figure 1 is shown a circuit having two inputs 11 and 12 and one output 13. A reference voltage from a voltage source is provided at input 11 and a signal which is to be analog to digital converted is provided at input 12. Input 11 is electrically connected to electrical resistor 14 and input 12 is electrically connected to resistor 15.

Also provided is an operational amplifier 17 having inputs 18 and 19 and an output which is electrically connected to the system output 13. Furthermore, input 18 is electrically connected to the output of operational amplifier 17 through electrical resistor 16. Input 19 of operational amplifier 17 is electrically connected to a source of a reference voltage, typically a source of ground potential. As illustrated in Figure 1, input 18 of operational amplifier 17 is an inverting input while input 19 is a non-inverting input. Those skilled in the art will readily perceive that this will cause the level shift to include an inversion of the signal.  If no such inversion is desired then the non-inverting input could be used to serve as input 18 of operational amplifier 17 and the inverting input could be used to serve as input 19.

By properly selecting operational amplifier 17 and the value of electrical resistor 16 and setting $V_{REF}$ equal to 5 volts the value of $V_{OUT}$ may be made equal to $-V_B(r_{16}/r_{15}) - 5.0(r_{16}/r_{14})$ where $r_{14}$, $r_{15}$, and $r_{16}$ are the electrical resistance values of resistors 14, 15, and 16, respectively.

To see how this may be used to enhance the dynamic range of an analog to digital converter turn to Figure 2.  In Figure 2 resistor 14 has been replaced by three resistors 14A, 14B, and 14C. Further added to Figure 2 is switching element 20 and analog to digital converter 21 having a digital output 22.

Switching element 20 is adapted to select between resistors 14A, 14B, and 14C or to deselect all three.  Thus, $V_{REF}$ may be connected to input 18 of operational amplifier 17 through resistor 14A, through resistor 14B, or through resistor 14C, or $V_{REF}$ may be totally disconnected from input 18 of operational amplifier 17.

By selecting electrical resistor 15 to have a resistance equal to one quarter the resistance value of resistor 16 and selecting resistor 14A to have a resistance equal to that of resistor 16, resistor 14B to have a resistance one half of that of resistor 16 and resistor 14C to have a resistance of one third that of resistor 16 a desirable combination of voltage shifts may be obtained. If those resistors have the stated ratios when all of resistors 14A, 14B, and 14C are deselected the following equation applies:

$$V_{OUT} = -4V_B$$

When resistor 14a is selected the following equation applies:

$$V_{OUT} = -4V_B - 5.0$$

When resistor 14b is used the following equation applies:

$$V_{OUT} = -4V_B - 10.0$$

When resistor 14c is used the following equation applies:

$$V_{OUT} = -4V_B - 15.0$$

Thus, if the input signal, $V_B$ is between 0 and -1.25V then all of resistors 14A, 14B, and 14C are deselected and the output of operational amplifier 17 will be in the range of 0 to 5 volts. Similarly, if the signals $V_B$ is between -1.25 and -2.50V resistor 14A is selected and the output will be again in the range of 0 to 5 volts. Similarly, if the signal $V_b$ is in the range of -2.5 to -5.0 volts using resistors 14B and 14C will provide an output in the range of 0 to 5 volts. Thus, A to D converter 21 should be, for this embodiment, capable of resolving signals in the 0 to 5 volt range.

As described above, there are four possible selections of connections for the $V_{REF}$ signal. It may be totally disconnected from the circuit or it may be connected to the circuit through resistor 14A, 14B, or 14C. Because there are four possible combinations, the one selected may be described by a two bit binary number. If analog to digital converter 21 is selected to be an 8 bit analog to digital converter, the total resolution of the system will be 10 bits, 8 bits from analog to digital converter 21 and 2 bits from the selection of the way $V_{REF}$ is connected to input 18 of analog to digital converter 17.

Turning now to Figure 3 an embodiment of the invention in which a plurality of analog input signals are multiplexed through analog to digital converter 21 is shown. Analog to digital converter 21 of Figure 3 includes eight analog signal input terminals 13 and 23A, 23B, 23C, 23D, 23E, 23F, and 23G. Also shown in Figure 3 is a control input 25 of analog to digital converter 21. Control input 25 of analog to digital converter 21 accepts timing signals for use in the analog to digital conversion process and also includes signals which cause analog to digital converter to select one of the analog input signals on analog signal input lines 13 and 23A through 23G. If one of analog input terminals 23A through 23G is selected, the results will be an output signal at digital signal output terminal 22 of analog to digital converter 21 with a number of bits equal to the resolution of analog to digital encoder 21, for example 8 bits.

Figure 3 also differs from Figure 2 in that analog input terminal 12 has been replaced by 8 analog input terminals designated 12A through 12H. These are electrically connected to switch set 30 which selects which of those 8 analog inputs will be connected via output 31 to electrical resistor 15 and hence will be analog to digital converted. Control signals provided to control signal input terminal 26 of switch set 30 will determine which of terminal inputs 12A through 12H will be utilized at any given time. When analog to digital converter 21 selects the signal from terminal 13 control signals presented at control input terminal 24 of switch set 20 will determine which, if any, of electrical resistors 14A, 14B, and 14C will be utilized. Thus, as described with respect to Figure 2, an 8 bit analog output may be obtained at output 22 of analog to digital converter 21, with two additional bits of resolution being obtained from the status of switches 20.

Those skilled in the art will readily perceive that the present invention is not limited to the specific embodiment described. For example, if additional resolution were desired more resistors could be provided connected to switch set 20. For example, if three additional bits of resolution were required, resistors 14A, 14B, and 14C could be replaced by a group of seven different resistrors. In this way there would be eight choices of resistors rather than four and three additional bits of resolution would be obtained. By shifting the level of the input signal fed to the A/D-converter a converter having a predetermined range of input signals (e.g. 0 to -1,25 V) can convert signals extending over a larger range (e.g. 0 to -5 V). This corresponds to an enhanced resolution of the converter.

CLAIMS:

1. Apparatus for enhancing the resolution of an analog to digital converter, c h a r a c t e r i z e d   b y
    a) first (11) and second (12) apparatus input terminals, said first apparatus input terminal (11) being adapted to be electrically connected to a source $V_{REF}$ of a first reference voltage and said second apparatus input terminal (12) being adapted to accept an analog signal ($V_B$) to be analog to digitally converted;
    b) a group of first electrical resistors (14A to 14C) electrically connected with a first end to said first apparatus input terminal (11);
    c) first switching means (20) having a plurality of input terminals electrically connected to the second end of said first electrical resistors (14A to 14C), said first switching means being capable of connecting one or none of its inputs to its output (18);
    d) a second electrical resistor (15) electrically connected between said apparatus second input terminal (12) and the output (18) of the first switching means (20);
    e) an amplifier (17) having first (18) and second (19) input terminals and an output terminal (13), said amplifier first input terminal (18) being electrically connected to the output (18) of the first switching means (20), said amplifier second input terminal (19) being adapted to be electrically connected to a source of a second reference voltage (ground) and the output (13) of said amplifier
being connected to a signal input (13) of an analog to
digital converter (21);

f) a feedback resistor (16) connected between the first input
terminal (18) and the output (13) of the amplifier (17).

2. An apparatus according to claim 1,    c h a r a c t e r -
i z e d    b y

g) said first switching means (20) including a control input
(24) responsive to first control signals to selectively
couple one or none of the inputs (14A to 14C) of the first
switching means (20) to its output (18);

h) second switching means (30) having a plurality of second
inputs (12A to 12H) and a second output (31), each of said
first inputs receiving a predetermined anlog input signal
from a group of analog input signals, said second
switching means (30) including a control input (26)
receiving a second control signal, whereby one of said
second inputs (12A to 12H) is coupled to said second
output (31);

i) the first input (18) of the amplifier (17) being coupled
to the output of the first switching means (20) and to the
output (31) of the second switching means (30);
whereby said first control signal (24) selectively connect
one or none of the inputs of said first switching means
(20) to its output for each predetermined analog input
signal of the second switching means (30).

3. Apparatus according to claim 2, c h a r a c t e r i z e d
   i n   t h a t   the digital to analog converter (21) includes
   a control input (25) responsive to third control signals for
   selectively receiving the output signal of said amplifier
   (17) or each of a second group (23A to 23G) of analog signals
   for analog to digital conversion.

FIG.1

FIG.2

FIG.3